Europäisches Patentamt

European Patent Office

Office européen des brevets

(11) Publication number: **0 111 096**
**B1**

## (12) EUROPEAN PATENT SPECIFICATION

(45) Date of publication of patent specification: **27.07.88**

(51) Int. Cl.⁴: **G 01 D 11/02, G 01 R 5/16**

(21) Application number: **83110123.3**

(22) Date of filing: **11.10.83**

(54) **Electrical meter.**

(30) Priority: **14.10.82 GB 8229390**

(43) Date of publication of application:
**20.06.84 Bulletin 84/25**

(45) Publication of the grant of the patent:
**27.07.88 Bulletin 88/30**

(84) Designated Contracting States:
**AT BE CH DE FR GB IT LI LU NL SE**

(56) References cited:
**GB-A-2 064 141**
**US-A-2 658 805**
**US-A-3 414 817**
**US-A-4 227 148**

(73) Proprietor: **HOWARD BUTLER LIMITED**
**Crown Works, Lincoln Road**
**Walsall West Midlands (GB)**

(72) Inventor: **Hughes, Derek John**
**40, Baswich Crest**
**Weeping Cross Stafford (GB)**

(74) Representative: **Harrison, Gordon Donald et al**
**FORRESTER & BOEHMERT Widenmayerstrasse**
**4/I**
**D-8000 München 22 (DE)**

Courier Press, Leamington Spa, England.

## Description

This invention relates to an electrical meter of the type, herein called the moving magnet type, which includes a fixed magnet, a moving magnet secured to a rotatable spindle which operates a pointer, and a conductor which extends adjacent to the moving magnet so that a current flowing in the conductor produces a magnetic field which reacts with the moving magnet to give rise to a rotational force thereon.

Electrical meters of the moving magnet type have been constructed with a conductor in the form of a flat strip disposed adjacent to the moving magnet, and have the advantage that they are generally cheaper to construct than moving iron type meters which require a wound coil. However, moving iron type meters can more easily be adopted to cover a wider range of operating currents, simply by varying the characteristics of the coil. Whilst the current required to produce full scale deflection in a moving magnet type of meter can be varied by varying the strength of one of the magnets, in practice, utilising conventional designs, we have not found it possible to produce a variation which will cover a wide range of full scale deflection current values without using a series of wound coils to provide the different sensitivities required.

One problem is the relative lock of sensitivity at low currents where low magnetic field strength is used. A further problem arises from friction to the spindle bearings, and this in turn is related to the design of such bearings and permissible manufacturing tolerances, porticularly in the axial spacing between such bearings.

Where, as for exomple in USA-A-4,227,148, the spindle is mounted in bearings formed both in the same component, or as for example in USA-A-3,414,817 between two separate components, the manufacturing tolerances are required to be very precise. If one bearing is made to be adjusted relative to the other, whilst this arrangement would be satisfactory, it is relatively expensive to produce, and also requires a comparatively skilled setting up operation.

It is also known from USA-A-2,658,805 to employ a form of magnetic suspension to reduce friction on the spindle, but at the expense of increasing the moving moss in a manner contrary to the requirements of improved sensitivity.

It is an object of the present invention to provide an improved electrical meter of the moving magnet type wherein one or more of the above stated disadvantages are overcome or at least subtantially reduced.

According to the invention, we provide a meter of the moving magnet type which includes a fixed magnet, a moving magnet secured to a rotatable spindle which operates a pointer, and a conductor which extends adjacent to the moving magnet so that a current flowing in the conductor produces a magnetic field which reacts with the moving magnet to give rise to a rotational force thereon, characterised in that a first end of the spindle is located in a seating formed in a first mounting part, a second end of the spindle is located in an axially, movable manner in a bearing hole formed in a second mounting part, and a magnetic shield is provided at a position adjacent to said moving magnet on the side thereof remote from the second end of the spindle in such a manner that magnetic interaction between the shield and the moving magnet urges the first end of the spindle towards its seating.

The attractive force exerted between the shield and the moving magnet can be so arranged, by suitable selection of field strengths and dimensions, as to ensure that there is at all times a net axial force acting on the spindle to urge it into the bearing provided on the conductor despite the force acting in the opposite direction as a result of the attraction between the two magnets.

Preferably the moving magnet is carried by the spindle at a position adjacent to the first end thereof and the first mounting part comprises a part of the conductor which extends parallel to said moving magnet. In that case, the magnetic shield is preferably disposed adjacent to the first mounting part on the side thereof remote from the moving magnet.

The fixed magnet may be disposed adjacent to the second end of the spindle and to vary the current required to produce full scale deflection, the spacing between the two magnets may be varied, for example by the use of spacers between the fixed magnet and the casing. Alternatively, fixed magnets of different thicknesses may be employed, or the number of standard thickness fixed magnets may be varied.

The second mounting part is conveniently formed as a casing part whereby the first mounting part is also supported, and when said first mounting part commprises the conductor, it preferably includes transverse parts which extend past the edges of the moving magnet in close proximity thereto.

The meter may operate as an ammeter, having a full scale deflection selected to be one of a range of values from about 3 to about 15A, by suitable variation of the strength and spacing of the magnets without otherwise altering the design. The meter may be adapted for conversion for use at lower values of full scale deflection by substituting a wound coil for the conductor strip ond for use as a volt meter by the incorporation af a suitable resistor in addition to such a coil.

The invention will now be described by way of example, with reference to the accompanying drawings wherein:-

FIGURE 1 shows a medial section through a meter in accordance with the invention; and

FIGURE 2 shows a fragmentary section on reduced scale on the line II-II of Figure 1.

Referring to the accompanying drawings, the embodiment illustrated therein commprises a one-piece moulded casing 10 having a transparent front cover plate 11 received within a rebate 12. The casing is formed with a recess 13 for the reception of anciliary parts, such as resis-

tors or a wound coil (not shown) for the reasons hereinafter explained, which recess is itself closed by a plate 14 carrying a scale (not shown). A pointer 15 which is movable over the scale is formed integrally with a spindle 16 as an injection moulding of a suitable plastics material. The innermost end 16a of the spindle is guided within a hollow bush 17 formed integrally in the casing 10, and includes an axially extending pin 18 of reduced diameter which extends into and through a bearing hole 19 formed in the casing 10. As can be seen, the axial length of the bearing surface afforded by the hole 19 is substantially less than the axial length of the pin 18 so as to minimise frictional contact, and this is achieved by forming a conical depression 20 on the outside of the casing 10 in alignment with the hole 19. It will thus be seen that the spindle 16 is supported at its innermost end 16a in a manner which allows a significant degree of axial movement so as to allow for manufacturing tolerances with regard to the length of the spindle, and also the axial position of the bearing at the outermost end of the spindle as described below.

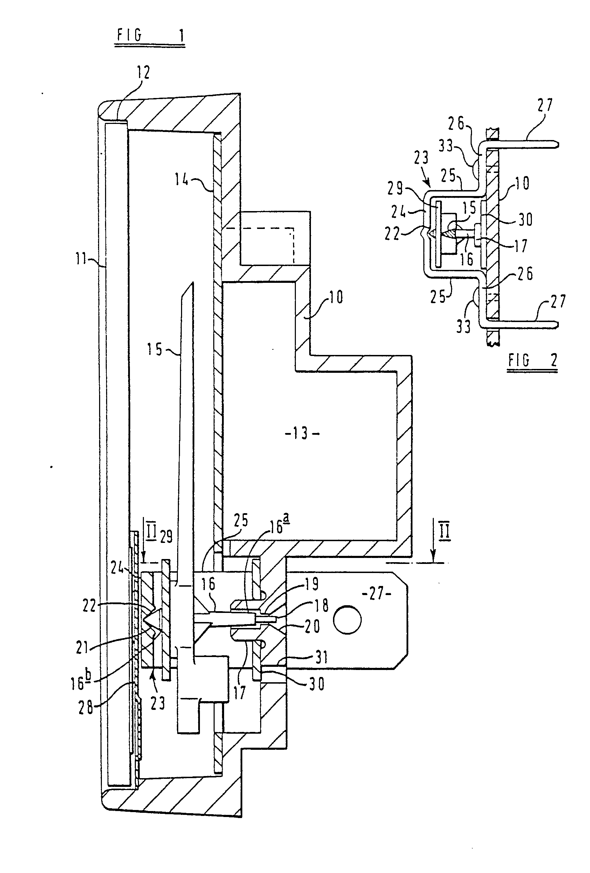

The spindle 16 is formed at its outermost end 16b with a conical bearing surface 21 which is received within a seating comprising a similarly shaded recess 22 formed in a mounting part which comprises the central portion 24 of a conductor strip 23. The conductor strip 23, as best seen in Figure 2, includes a pair of spaced parallel terminal portions 27 which extend outwardly through the casing 10, and a pair of co planar locating portions 26 which extend transversely relative to the terminal portions 27 and engage the inner face of the casing 10 adjacent thereto, the conductor strip 23 being secured to the casing by means of rivets 33. The central portion 24 of the conductor strip 23 is disposed in spaced parallel relationship to the locating portions 26 and is integrally connected therewith by means of spacer portions 25 which extend parallel to the terminal portions 27.

A fixed, disc-like magnet 30 is located on the boss 17 adjacent to the inner end 16a of the spindle, whilst a similar, moving magnet 29 is carried at the outer end 16b of the spindle 16 at a position immediately adjacent to the conical bearing surface 21. It will be noted that the moving magnet 29 is spaced closely adjacent and parallel to the central portion 24 of the conductor strip 23, and that the spacer portions 25 of the conductor extend past the edge of the magnet 29, in close proximity thereto.

A magnetic shield 28 is supported by the casing 10 and held in position by the cover plate 11, at a position closely adjacent to the central portion 24 of the conductor strip 23. The shield 28 may be of any suitable permalloy type material of high magnetic permeability. Various Fe-Ni alloys are available for this purpose, for example "Mumetal" or preferably "Radiometal".

The two magnets 29 and 30 are each magnetised along a diameter and attract one another in the axial direction with a force which is at a maximum when the pointer is at the "zero" position. However, the shield 28 is arranged in the proximity of the moving magnet 29 with the result that not only does it act as a shield against external magnetic fields but also the magnet 29 is actually attracted towards the shield. Such attractive force is utilised in this design to urge the spindle bearing surface 21 towards the recess 22 and relieve the bearing of the innernost end of the spindle of any part in the axial positioning af the spindle, leaving such bearing to locate the spindle only radially with minimum frictional contact. By suitable selection of the various dimensions, it can be ensured that even at zero deflection there is a net force on the spindle holding it in engagement with·the conductor strip.

It will be appreciated that this arrangement minimises the frictional forces acting on the spindle without increasing the moving mass and also makes possible a relaxation in the standards of tolerance on the dimensions of the various parts.

The movement is assembled with the casing 10 in a very simple manner. After the fixed magnet 30 has been placed in position on the boss 17, and the scale plate 1 has been placed over the recess 13, the spindle 16 is inserted into the hollow boss so that the pin 18 extends through the hole 19. The pointer assembly comprising pointer 15, spindle 16 and moving magnet 29, is substantially self-supporting in the required position, and when the conductor strip 23 is placed over this assembly, with the terminal portions 27 extending through appropriate slots in the casing 10, the conical bearing surface 21 of the spindle is guided into the corresponding bearing surface 22. The rivets 33 are then applied to secure the conductor strip in position, and finally the magnetic shield 28 is placed in position and retained by the transparent cover plate 11 which is a snap fit within the rebate 12. Any necessary zero adjustment may be effected by appropriate angular movement of the fixed magnet 30 about the boss 17, and for this purpose an access aperture 31 is formed in the housing, the periphery of the magnet 30 preferably being formed with a small recess far engagement by a suitable tool.

After assembly, the meter may be collibrated by de-magnetising or remagnetising the fixed magnet 30 by the extent necessary to produce full scale deflection at the intended current value.

One or more spacers may be inserted between the fixed magnet 30 and the casing 10 in order to vary the spacing between the fixed and moving magnets for the purpose of providing a range of meters with differing values of full scale deflection currents. Alternatively, a range of fixed magnets of differing thicknesses may be employed for the same purpose.

Whilst it is particularly convenient to form the recess 22 in the conductor strip 23, it would alternatively be possible for the spindle to extend through a hole in the strip and engage in a recess formed on a separate member, such as the magnetic shield 28.

The embodiment illustrated and described functions as an ammeter which may have a full scale deflection in the range from about 3-A to 15-A according to the strength and spacing of the two magnets. These factors may readily be varied to produce meters having a full scale deflection of for example 3A, 4A, 6A, 8A, 10A, 12A and 15A. However, the meter can also be adapted simply to operate at a lower range of values down to -mA. This can be achieved by replacing the conductor strip 23 by a similar member without the terminal portions 27 and utilising separate terminal members connected to a suitable wound coil located in the recess 13 which functions as a solenoid interacting with the magnetic flux between the magnets. By additionally incorporating a resistor, the meter may also be converted to function as a volt meter.

The mechanism consisting of the moving assembly of spindle 16, magnet 29 and pointer 15 and the mounting assembly of conductor strip 23 with the associated magnet 30 and shield 28 can thus be used in a wide range of different instruments and is simple in construction and easy to assemble.

The features disclosed in the foregoing description, in the following claims and/or in the accompanying drawings may, both separately and in any combination thereof, be material for realising the invention in diverse forms thereof.

**Claims**

1. A meter of the moving magnet type which includes a fixed magnet (30), a moving magnet (29) secured to rotatable spindle (16) which operates a pointer (15), and a conductor (23) which extends adjacent to the moving magnet (29) so that a current flowing in the conductor (23) produces a magnetic field which reacts with the moving magnet (29) to give rise to a rotational force thereon, characterised in that a first end (16b) of the spindle (16) is located in a seating (22) formed in a first mounting part (24), a second end (16a) of the spindle is located in an axially movable manner in a bearing hole (19) formed in a second mounting part (10), and a magnetic shield (28) is provided at a position adjacent to said moving magnet (29) on the side thereof remote from the second end (16a) of the spindle in such a manner that magnetic interaction between the shield (28) and the moving magnet (29) urges the first end (16b) of the spindle (16) towards its seating (22).

2. A meter according to Claim 1 wherein the moving magnet (29) is carried by the spindle (16) at a position adjacent to said first end (16b) thereof and said first mounting part (24) comprises a port of the conductor (23) which extends parallel to said moving magnet.

3. A meter according to Claim 2 wherein the magnetic shield (28) is disposed adjacent to the first mounting part (24) on the side thereof remote from the moving magnet (29).

4. A meter according to any one of the preceding claims wherein the second end (16a) of the spindle (16) is guided within a boss (17) and includes an axil pin (18) which extends through said bearing hole (19).

5. A meter according to Claim 4 wherein the axial length of the pin (18) is greater than the axial length of the bearing face afforded by the hole (19).

6. A meter according to any one of the preceding claims wherein the first end (16b) of the spindle (16) is formed as a conical bearing surface (21) and the seating (22) in the first mounting part (24) is formed as a conical recess.

7. A meter according to any one of the preceding claims wherein the fixed magnet (30) is disposed adjacent to the second end (16a) of the spindle (16).

8. A meter according to any one of the preceding claims wherein the second mounting part is formed as an integral part of a casing (10) whereby the first mounting part (24) is also supported.

9. A meter according to Claim 8 wherein the conductor (23) includes transverse parts (25) which extend past the edges of the moving magnet (29) in close proximity thereto.

**Patentansprüche**

1. Drehmagnet-Meßgerät mit einem ortsfesten Magneten, einem auf einer einen Zeiger (15) betätigenden Drehwelle (16) befestigten beweglichen Magneten (29) und einem Leiter (23), der sich benachbart dem beweglichen Magneten (29) erstreckt, so daß ein Stromfluß in dem Leiter (23) ein magnetisches Feld erzeugt, das mit dem beweglichen Magnet (29) ein Drehmoment bewirkt, dadurch gekennzeichnet, daß ein erstes Ende (16b) der Welle (16) in einem in einem ersten Befestigungsteil (24) ausgebildeten Sitz (22) angeordnet ist, ein zweites Ende (16a) der Welle axial beweglich in einer in einem zweiten Befestigungsteil (10) ausgebildeten Lagerbohrung axial beweglich angeordnet ist, und eine magnetische Abschirmung (28) vorgesehen ist an einem Ort benachbart zu dem beweglichen Magneten (29) an dessen dem zweiten Ende (16a) der Welle entfernten Seite derart, daß die magnetische Wechselwirkung zwischen der Abschirmung (28) und dem beweglichen Magneten (29) das erste Ende (16b) die Welle (16) gegen ihren Sitz (22) zwingt.

2. Meßgerät nach Anspruch 1, wobei der bewegliche Magnet von der Welle (16) an einem Ort benachbart dessen ersten Ende (16b) getragen wird der erste Befestigungsteil (24) einen Teil des Leiters (23) aufweist, der sich parallel zu dem beweglichen Magneten erstreckt.

3. Meßgerät nach Anspruch 2, wobei die magnetische Abschirmung (28) benachbart zu dem ersten Befestigungsteil (24) an dessen von dem beweglichen Magneten (29) entfernten Seite angeordnet ist.

4. Meßgerät nach einem der vorangehenden Ansprüche, wobei das zweite Ende (16a) der Schwelle (16) in einer Nabe (17) geführt wird und einen axialen Stift (18) aufweist, der sich durch die Lagerbohrung (19) erstreckt.

5. Meßgerät nach Anspruch 4, wobei die axiale Länge des Stiftes (18) größer ist als die axiale Länge der durch die Bohrung (19) geschaffenen Fläche.

6. Meßgerät nach einem der vorangehenden Ansprüche, wobei das erste Ende (16b) der Welle (16) als eine konische Lagerfläche (21) und der Sitz (22) in dem ersten Befestigungsteil (24) als konische Ausnehmung ausgebildet sind.

7. Meßgerät nach einem der vorangehenden Ansprüche, wobei der feste Magnet (30) benachbart dem zweiten Ende (16a) der Welle (16) angeordnet ist.

8. Meßgerät nach einem der vorangehenden Ansprüche, wobei der zweite Befestigungsteil als integraler Bestandteil eines Gehäuses (10) ausgebildet ist, durch das auch das erste Befestigungsteil (24) getragen wird.

9. Meßgerät nach Anspruch 8, wobei der Leiter (24) sich quer erstreckende Abschnitte aufweist, die sich hinter die Kanten des beweglichen Magneten (29) in großer Nähe zu dieser erstrecken.

## Revendications

1. Compteur du type à aimant mobile, comportant un aimant fixe (30), un aimant mobile (29) fixé à un pivot rotatif (16) qui entraîne une aiguille (15), et un conducteur (23) qui s'étend au voisinage de l'aimant mobile (29) de façon qu'un courant parcourant le conducteur (23) produise un champ magnétique qui agit sur l'aimant mobile (29) pour exercer sur celui-ci une force qui le fait tourner, caractérisé en ce qu'une première extrémité (16b) du pivot (16) est logée dans un siège (22) ménagé dans une première pièce support (24), en ce que la seconde extrémité (16a) du pivot est logée de façon à être mobile axialement dans un trou d'appui (19) ménagé dans une seconde pièce support (10), et en ce qu'un écran magnétique (28) est prévu dans une position voisine de l'aimant mobile (29) du côté de celui-ci opposé à la seconde extrémité (16a) du pivot d'une manière telle que l'interaction magnétique entre l'écran (28) et l'aimant mobile (29) rappelle la première extrémité (16b) du pivot (16) vers son siège (22).

2. Compteur conforme à la revendication 1, dans lequel l'aimant mobile (29) est porté par le pivot (16) en une position voisine de la première extrémité (16b) de celui-ci, et en ce que la première pièce support (24) consiste en une partie du conducteur (23) qui s'étend parallèlement à l'aimant mobile.

3. Compteur conforme à la revendication 2, dans lequel l'écran magnétique (28) est disposé au voisinage de la première pièce support (24) du côté de celle-ci opposé à l'aimant mobile (29).

4. Compteur conforme à l'une quelconque des revendications précédentes, dans lequel la seconde extrémité (16a) du pivot (16) est guidée dans un bossage (17) et présente une broche axiale (18) qui traverse le trou d'appui (19).

5. Compteur conforme à la revendication 4, dans lequel la longueur axiale de la broche (18) est supérieure à la longueur axiale de la face d'appui constituée par le trou (13).

6. Compteur conforme à l'une quelconque des revendications précédentes, dans lequel la première extrémité (16b) du pivot (16) a la forme d'une surface d'appui conique (21) et le siège (22) ménagé dans la première pièce support (24) a la forme d'un évidement conique.

7. Compteur conforme à l'une quelconque des revendications précédentes, dans lequel l'aimant fixe (30) est disposé au voisinage de la seconde extrémité (16a) du pivot (16).

8. Compteur conforme à l'une quelconque des revendications précédentes, dans lequel la seconde pièce support fait partie intégrante d'un boîtier (10) qui sert également de support à la première pièce support (24).

9. Compteur conforme à la revendication 8, dans lequel le conducteur (23) comporte des parties transversales (25) qui s'étendent au-delà des bords de l'aimant mobile (29) au voisinage immédiat de ceux-ci.

FIG 1

FIG 2